(19)

Europäisches
Patentamt
European
Patent Office
Office européen
des brevets

(11) **EP 2 940 855 A1**

(12) **EUROPEAN PATENT APPLICATION**
published in accordance with Art. 153(4) EPC

(43) Date of publication:
**04.11.2015 Bulletin 2015/45**

(21) Application number: **12891179.9**

(22) Date of filing: **31.12.2012**

(51) Int Cl.:
***H02N 2/14*** *(2006.01)*

(86) International application number:
**PCT/KR2012/011837**

(87) International publication number:
**WO 2014/104452 (03.07.2014 Gazette 2014/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **LG Electronics Inc.
Yeongdeungpo-gu
Seoul 150-721 (KR)**

(72) Inventors:
• **CHO, Youngjun
Seoul 137-724 (KR)**

• **JOUNG, Munchae
Seoul 137-724 (KR)**
• **KIM, Sunuk
Seoul 137-724 (KR)**

(74) Representative: **Katérle, Axel
Wuesthoff & Wuesthoff
Patentanwälte PartG mbB
Schweigerstraße 2
81541 München (DE)**

(54) **DEVICE AND METHOD FOR GENERATING VIBRATIONS**

(57) A device and method for generating vibrations in a portable terminal are disclosed. The device for generating vibrations comprises: a haptic actuator which is driven by a driving signal so as to generate vibrations; and a control unit for applying the driving signal to the haptic actuator, causing the haptic actuator to have a high impedance and controlling a start time of the driving signal of non-periodic pulses to be applied to the haptic actuator, on the basis of a counter-electromotive force signal generated by the haptic actuator.

FIG. 8

EP 2 940 855 A1

**Description**

[Technical Field]

The present invention relates to a portable device and, more particularly, to a vibration generating apparatus and method for generating vibration in a portable device.

[Background Art]

A haptic feedback (hereinafter referred to as a haptic function) has a meaning including a force feedback function for remote control of a robot arm, a vibration function of a small information device, etc., and refers to means for expressing information based on user touch or contact. Currently, the haptic function is used as a function for confirming normal input of a signal value of a key touched on a screen by a user as well as a vibration function for notifying an incoming call in a portable device such as a cellular phone.

In general, when a text message or an incoming call is received, a portable device provides a vibration mode to notify the same. The portable device includes a haptic actuator for operation in this vibration mode. The haptic actuator is also called a vibration actuator or a vibration element, and includes an eccentric motor, a linear resonant actuator (LRA), a piezo actuator, etc.

Particularly, as a whole front surface of a portable device is implemented as a touch screen, research is being conducted on haptic senses capable of providing immersion through realistic and interesting feelings in addition to button touch and visual information display. That is, a haptic actuator of a portable device generates vibration as feedback on an incoming call or a user input.

When a haptic actuator is conventionally driven to generate vibration, a driving waveform is preliminarily formed using a preset resonant frequency and then the haptic actuator is driven. However, the resonant frequency may be changed due to a physical impact such as a fall or the state and mass of a portable device including the haptic actuator.

For example, a portable device for generating vibration to notify an incoming call has a small size and can be carried in various forms. That is, the portable device can be carried while being hooked on a necklace, hand-held by a user, or inserted into a packet or a bag. Due to these different forms of carrying, portable devices including haptic actuators may have different resonant frequencies. As another example, the resonant frequency may be changed based on the mass of a battery mounted on the portable device. As described above, the portable device drives the haptic actuator using a driving signal having a single resonant frequency determined in a manufacturing process. Accordingly, even when a resonant frequency for generating the maximum vibration is changed based on system aging, physical impact, mass variation, or the like, a haptic actuator cannot be driven appropriately for the change and thus the level of vibration is reduced.

In addition, an error may occur in a resonant frequency when a haptic actuator is produced in large quantities. That is, the resonant frequency of the haptic actuator has a certain error range in terms of design. In this case, the error range should be very small to apply a method for driving the haptic actuator based on a driving signal formed using a preliminarily-known resonant frequency. However, this serves as a major cause of increasing an error rate. That is, even a small error which does not actually causes a problem is not allowed for a current controller. This serves as a major cause of reducing price competitiveness, and thus a method for reducing an error rate is necessary.

[Disclosure]

[Technical Problem]

An object of the present invention devised to solve the problem lies in a vibration generating apparatus and method for generating the maximum vibration even when a resonant frequency is changed, by driving a haptic actuator while tracing a resonance point using a back electromotive force (EMF).

Another object of the present invention devised to solve the problem lies in a vibration generating apparatus and method for generating the maximum vibration even when a resonant frequency is changed, by driving a haptic actuator having multiple resonant frequencies while tracing a resonance point using a back EMF.

Another object of the present invention devised to solve the problem lies in a vibration generating apparatus and method capable of easily controlling residual vibration using a back EMF.

[Technical Solution]

To achieve these objects and other advantages and in accordance with the purpose of the disclosure, as embodied and broadly described herein, a vibration generating apparatus may include a haptic actuator for generating vibrations by driving according to a driving signal, and a controller for applying the driving signal of a half-cycle pulse to the haptic actuator, making high impedance state of the haptic actuator, and then controlling a start timing of a subsequent half-cycle pulse of the driving signal to be applied to the haptic actuator based on a back electromotive force (EMF) signal generated by the haptic actuator. Herein, the applying, the making, and the controlling may be repeated for a desired duration of vibration, and a direction of the half-cycle pulse may be switched to an opposite direction whenever the driving signal of the half-cycle pulse is applied to the haptic actuator.

A period of the half-cycle pulse of the driving signal may be set to be less than a period of a half-cycle pulse corresponding to a preset resonant frequency.

The controller may determine a zero crossing point of the back EMF signal as the start timing of the half-cycle pulse of the driving signal.

The controller may determine an extreme point of the back EMF signal as the start timing of the half-cycle pulse of the driving signal.

The controller may generate a residual vibration control signal based on the back EMF signal generated by the haptic actuator and apply the generated residual vibration control signal to the haptic actuator, if the desired duration of vibration has passed.

The residual vibration control signal may be applied to the haptic actuator on a half-cycle pulse basis, and a direction of an initial half-cycle pulse of the residual vibration control signal may be the same as a direction of a last half-cycle pulse of the driving signal.

A period of the half-cycle pulse of the driving signal may be the same as a period of a half-cycle pulse of the residual vibration control signal.

The controller may determine a zero crossing point of the back EMF signal as a start timing of a half-cycle pulse of the residual vibration control signal.

The controller may determine an extreme point of the back EMF signal as a start timing of a half-cycle pulse of the residual vibration control signal.

A line for applying the driving signal may be the same as a line for feeding back the back EMF signal.

In another aspect of the present disclosure, a vibration generating method for generating vibrations by driving a haptic actuator may include applying a driving signal of a half-cycle pulse to the haptic actuator and making high impedance state of the haptic actuator, detecting a back electromotive force (EMF) signal generated in the high impedance state by the haptic actuator, determining a start timing of a subsequent half-cycle pulse of the driving signal to be applied to the haptic actuator based on the detected back EMF signal, and applying the half-cycle pulse of the driving signal to the haptic actuator at the determined start timing. Herein, the applying and making, the detecting, and the determining and applying may be repeated for a desired duration of vibration, and a direction of the half-cycle pulse may be switched to an opposite direction whenever the driving signal of the half-cycle pulse is applied to the haptic actuator.

The vibration generating method further includes selecting one of multiple resonant frequencies if the haptic actuator is a multi-resonant haptic actuator.

[Advantageous Effects]

According to the present invention, by driving a haptic actuator while tracing a resonance point using a back (or counter) electromotive force (EMF) signal, if a haptic actuator is changed due to an internal/external factor, the haptic actuator may be driven with the changed resonant frequency. Particularly, according to the present invention, even a multi-resonant haptic actuator having multiple resonant frequencies may be driven by tracing a resonance point for generating the maximum vibration for each resonant frequency.

In addition, according to the present invention, by controlling residual vibration using a back EMF signal, residual vibration may be rapidly reduced or suppressed. As such, the life of a haptic actuator may be increased and phantom vibration syndrome caused by residual vibration of the haptic actuator may be prevented.

[Description of Drawings]

FIG. 1 is a block diagram of a portable device according to an embodiment of the present invention.

FIG. 2 is a block diagram of a vibration generating apparatus according to an embodiment of the present invention.

FIG. 3 is a circuit diagram of the vibration generating apparatus according to an embodiment of the present invention.

FIG. 4 is a perspective view of a haptic actuator according to an embodiment of the present invention.

FIG. 5(a) is a view showing an example in which a driving signal and a back electromotive force (EMF) signal are generated in a single line, according to an embodiment of the present invention.

FIG. 5(b) is a view showing an example of a signal detected from a general acceleration sensor.

FIG. 6(a) is a view showing an example of a resonant frequency according to an embodiment of the present invention.

FIG. 6(b) is a view showing an example of a single-cycle pulse corresponding to the resonant frequency of FIG. 6(a).

FIG. 6(c) is a view showing an example in which the resonant frequency is changed due to an internal/external factor, according to an embodiment of the present invention.

FIG. 7(a) illustrates a waveform showing an example in which a driving signal is generated and applied to the haptic actuator at zero crossing points of a back EMF signal on a half-cycle pulse basis, according to an embodiment of the present invention.

FIG. 7(b) illustrates a waveform showing an example in which a driving signal is generated and applied to the haptic actuator at extreme points of a back EMF signal on a half-cycle pulse basis, according to an embodiment of the present invention.

FIG. 8 is a flowchart of a vibration generating method according to an embodiment of the present invention.

FIG. 9(a) is a view showing an example in which residual vibration is controlled in a normal stop mode according to an embodiment of the present invention.

FIG. 9(b) is a view showing an example in which residual vibration is controlled in a breaking mode according to an embodiment of the present invention.

FIGS. 10(a) to 10(c) show an example of multiple resonant frequencies of a multi-resonant haptic actuator according to an embodiment of the present invention.

FIG. 11 is a flowchart of a vibration generating method according to another embodiment of the present invention.

FIG. 12 illustrates a waveform showing an example in which, when a resonant frequency selected among multiple resonant frequencies is changed, the haptic actuator is driven while tracing the changed resonant frequency, according to an embodiment of the present invention.

FIG. 13 illustrates a waveform showing another example in which, when a resonant frequency selected among multiple resonant frequencies is changed, the haptic actuator is driven while tracing the changed resonant frequency, according to an embodiment of the present invention.

[Best Mode]

Reference will now be made in detail to the preferred embodiments of the present invention, examples of which are illustrated in the accompanying drawings. The detailed description, which will be given below with reference to the accompanying drawings, is intended to explain exemplary embodiments of the present invention, rather than to show the only embodiments that can be implemented according to the present invention.

Prior to describing the present invention, it should be noted that most terms disclosed in the present invention are defined in consideration of functions of the present invention and correspond to general terms well known in the art, and can be differently determined according to intentions of those skilled in the art, usual practices, or introduction of new technologies. In some cases, a few terms have been selected by the applicant as necessary and will hereinafter be disclosed in the following description of the present invention. Therefore, it is preferable that the terms defined by the applicant be understood on the basis of their meanings in the present invention.

In association with the embodiments of the present invention, specific structural and functional descriptions are disclosed for illustrative purposes only and the embodiments of the present invention can be implemented in various ways without departing from the scope of the present invention.

While the present invention permits a variety of modifications and changes, specific embodiments of the present invention illustrated in the drawings will be described below in detail. However, the detailed description is not intended to limit the present invention to the described specific forms. Rather, the present invention includes all modifications, equivalents, and substitutions without departing from the spirit of the invention as defined in the claims.

In description of the present invention, the terms "first" and "second" may be used to describe various components, but the components are not limited by the terms. The terms may be used to distinguish one component from another component. For example, a first component may be called a second component and a second component may be called a first component without departing from the scope of the present invention.

Throughout the specification, when a certain part "includes" a certain element, it means that the part can further include other elements not excluding the other elements. Furthermore, the terms "unit" and "part" mean units which process at least one function or operation, which can be implemented by hardware, software, or combination of hardware and software.

The present invention may detect the resonant frequency of a haptic actuator having a plurality of resonant frequencies by using a back EMF signal and control residual vibration.

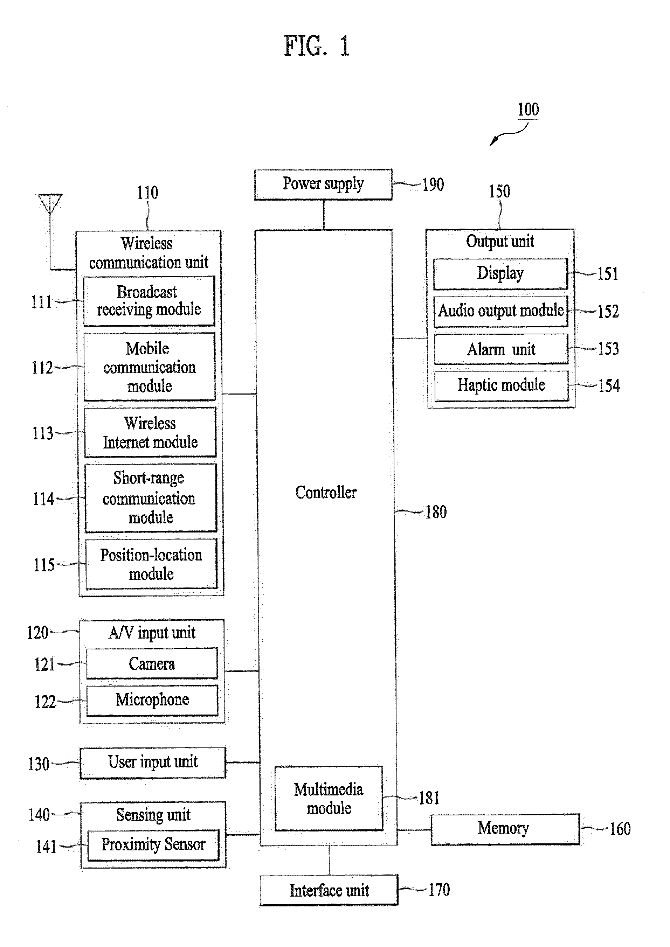

FIG. 1 is a block diagram illustrating constituent components of a portable device according to an embodiment of the present invention.

Referring to FIG. 1, the portable device 100 may include a wireless communication unit 110, an A/V (Audio/Video) input unit 120, a user input unit 130, a sensing unit 140, an output unit 150, a memory 160, an interface unit 170, a controller 180, a power supply unit 190, etc. FIG. 1 illustrates the portable device 100 having various components, but it is understood that implementing all of the illustrated components is not a requirement. The portable device 100 may be implemented by greater or fewer components.

The wireless communication unit 110 includes one or more components allowing radio frequency (RF) communication between the portable device 100 and a wireless communication system or a network in which the portable device 100 is located. For example, the wireless communication unit 110 may include a broadcast receiving module 111, a mobile communication module 112, a wireless Internet module 113, a short-range communication module 114, and a position information module 115.

The broadcast receiving module 111 receives broadcast signals and/or broadcast associated information from an external broadcast management server via a broadcast channel.

The broadcast channel may include a satellite channel and/or a terrestrial channel. The broadcast management server may be a server (or a broadcast station) that generates and transmits a broadcast signal and/or broadcast associated information, or a server (or a broadcast station) that receives a previously generated broadcast signal and/or broadcast associated information and transmits the same to the portable device. The broadcast signal may include a TV broadcast signal, a radio broadcast signal, a data broadcast signal, and the like. Also, the TV broadcast signal may further include a broadcast signal formed by combining the data broadcast signal with a TV or radio broadcast signal.

The broadcast associated information may refer to information associated with a broadcast channel, a broadcast program or a broadcast service provider. The broadcast associated information may also be provided via a mobile communication network and, in this case, the broadcast associated information may be received by the mobile communication module 112.

The broadcast associated information may exist in various forms. For example, it may exist in the form of an electronic program guide (EPG) of digital multimedia broadcasting (DMB), electronic service guide (ESG) of digital video broadcast-handheld (DVB-H), and the like.

The broadcast receiving module 111 may be configured to receive digital broadcast signals using various types of digital broadcast systems, for example, digital multimedia broadcasting-terrestrial (DMB-T), digital multimedia broadcasting-satellite (DMB-S), MediaFLO (Media Forward Link Only), digital video broadcast-handheld (DVB-H), integrated services digital broadcast-terrestrial (ISDB-T), mobile and handheld (MH), next generation handheld (NGH), etc. Of course, the broadcast receiving module 111 may be configured to be suitable for every broadcast system that provides a broadcast signal as well as the above-mentioned digital broadcast systems.

Broadcast signals and/or broadcast-associated information received via the broadcast receiving module 111 may be stored in the memory 160.

The mobile communication module 112 transmits and receives radio frequency (RF) signals to and from at least one of a base station (BS), an external terminal and a server. Such RF signals may include a voice call signal, a video call signal or various types of data according to text and/or multimedia message transmission and/or reception.

The wireless Internet module 113 supports wireless Internet access for the portable device 100. This module may be internally or externally coupled to the portable device 100. Here, as the wireless Internet technique, a wireless local area network (WLAN), Wi-Fi, wireless broadband (WiBro), world interoperability for microwave access (WiMAX), high speed downlink packet access (HSDPA), and the like, may be used.

The short-range communication module 114 is a module supporting short-range communication. Some examples of short-range communication technology include Bluetooth, Radio Frequency IDentification (RFID), Infrared Data Association (IrDA), Ultra-WideBand (UWB), ZigBee, and the like.

The position information module 115 is a module for checking or acquiring a position (or location) of the portable device. For example, the position information module 115 may include a GPS (Global Positioning System) module that receives position information from a plurality of satellites.

The A/V input unit 120 is used to input an audio signal or a video signal and may include a camera module 121, a microphone 122, and the like. The camera module 121 processes an image frame of a still image or a moving image acquired through an image sensor in a video communication mode or an image capture mode. The processed image frame may be displayed on a display unit 151.

The image frame processed by the camera 121 may also be stored in the memory 160 or may be transmitted to the outside through the wireless communication unit 110. The camera 121 may include two or more camera modules 121 depending on use environments.

The microphone 122 receives an external sound signal through a microphone and processes it into electrical audio data in a phone call mode or an audio recording mode, or a voice recognition mode. In the phone call mode, the processed audio data may be converted into a format transmittable to a base station (BS) through the mobile communication module 112. The microphone 122 may implement a variety of noise removal algorithms for removing noise occurring when receiving external sound signals.

The user input unit 130 generates key input data corresponding to key strokes that the user has entered for controlling the operation of the portable device. The user input unit 130 may include a keypad, a dome switch, a touchpad (including a static-pressure type and an electrostatic type), a jog wheel, a jog switch, and the like.

The user input unit 130 includes a sensor (hereinafter referred to as a touch sensor) for sensing a touch gesture, and may be implemented as a touchscreen layered with the display unit 151. That is, the user input unit 130 may be integrated with the display unit 151 into one module. The touch sensor may be configured in the form of a touch film, a touch sheet, or a touchpad, for example.

The touch sensor may convert a variation in pressure, applied to a specific portion of the display unit 151, or a variation in capacitance, generated at a specific portion of the display unit 151, into an electric input signal. The touch sensor may sense pressure, position, and an area (or size) of the touch.

When the user applies a touch input to the touch sensor, a signal corresponding to the touch input may be transmitted to a touch controller (not shown). The touch controller may then process the signal and transmit data corresponding to the processed signal to the controller 180. Accordingly, the controller 180 may detect a touched portion of the display unit 151.

The user input unit 130 is designed to detect at least one of a user's finger and a stylus pen. The controller 180 can recognize at least one of the position, shape and size of the touched region according to the sensing result of the touch sensor contained in the user input unit 130.

The sensing unit 140 detects a current state of the portable device 100 such as an open/closed state of the portable device 100, location of the portable device 100, acceleration or deceleration of the portable device 100, and generates a sensing signal for controlling the operation of the portable device 100. The sensing unit 140 also provides sensing functions associated with detection of whether or not the power-supply unit 190 supplies power or whether or not the interface unit 170 has been coupled with an external device. Meanwhile, the sensing unit 140 may include a proximity sensor 141. The sensing unit 140 may include a gyroscope sensor, an acceleration sensor, a geomagnetic sensor, etc.

The output unit 150 is provided to output an audio signal, a video signal, or a tactile signal and may include the display unit 151, a sound output module 152, an alarm unit 153, a haptic module 154, and the like.

The display unit 151 displays (outputs) information processed by the portable device 100. For example, when the portable device 100 is in a phone call mode, the display unit 151 may display a User Interface (UI) or a Graphical User Interface (GUI) associated with a call or other communication. When the portable device 100 is in a video call mode or image capture mode, the display unit 151 may display a captured image and/or received image, a UI or GUI that shows videos or images and functions related thereto, and the like.

The display unit 151 may include at least one of a Liquid Crystal Display (LCD), a Thin Film Transistor-LCD (TFT-LCD), an Organic Light Emitting Diode (OLED) display, a flexible display, a three-dimensional (3D) display, or the like.

Some parts of the display unit 151 may be turned on or off. In more detail, the display unit 151 can be switched on or off in units of LEDs, and LEDs associated with a predetermined screen region can be switched on or off. In this case, the LEDs associated with the predetermined screen region may be LEDs for illuminating a light beam to the predetermined screen region or may be LEDs located at positions associated with the predetermined screen region. For example, the LEDs may be OLEDs. In addition, lighting of the screen region may indicate lighting of LEDs associated with the corresponding screen region, and brightness adjusting of the screen region may indicate brightness of LEDs associated with the corresponding screen region.

Power can be supplied to LEDs of the display unit 151 on the basis of the LEDs, or the amount of power supply of the display unit 151 is adjusted in units of LEDs, such that the LEDs can be turned on or off and brightness of the LEDs can be adjusted.

Some of these displays may be configured into a transparent type or light transmission type displays, through which the outside can be seen. These displays may be referred to as transparent displays. A representative of the transparent displays is a transparent OLED (TOLED). The rear structure of the display unit 151 may also be configured into a light transmission type structure. In this structure, it is possible for a user to view objects located at the rear of the portable device body through a region occupied by the display unit 151 of the portable device body.

Two or more display units 151 may be provided depending on how the portable device 100 is realized. For example, the portable device 100 may include both an external display unit (not shown) and an internal display unit (not shown). For example, a plurality of display units may be spaced apart from one surface of the portable device 100 or be integrated in one. In addition, the display units may also be arranged at different surfaces, respectively.

If the display unit 151 and a sensor for sensing a touching action (hereinafter referred to as a touch sensor) are configured in the form of a layer, namely, if the display unit 151 and the touch sensor are configured in the form of a touchscreen, the display unit 151 may also be used as an input unit in addition to being used as the output unit. The touchscreen may be contained in the display unit 151, and the touch sensor may be contained in the user input unit 130.

The proximity sensor 141 of the sensing unit 140 may be disposed at an inner region of the portable device 100 surrounded by the touchscreen or in the vicinity of the touchscreen. The proximity sensor 141 is a sensor to sense whether an object has approached a predetermined sensing surface or is present in the vicinity of the predetermined sensing surface using electromagnetic force or infrared rays without mechanical contact. The proximity sensor 141 has longer lifespan and higher applicability than a contact type sensor.

Examples of the proximity sensor 141 may include a transmission type photoelectric sensor, direct reflection type photoelectric sensor, mirror reflection type photoelectric sensor, high frequency oscillation type proximity sensor, capacitive type proximity sensor, magnetic type proximity sensor and infrared proximity sensor. In a case in which the touchscreen is of an electrostatic type, the touchscreen is configured to sense approach of a pointer based on change of an electric field caused by the approach of the pointer. In this case, the touchscreen (touch sensor) may be classified as a proximity sensor. In the following description, a physical unit (such as a user's finger or stylus pen) capable of performing touch, proximity touch, touch gesture, etc. will hereinafter be collectively referred to as a "pointer".

In the following description, an action in which a pointer approaches the touchscreen without contact and it is recognized that the pointer is located on the touchscreen is referred to as "proximity touch", and an action in which a pointer directly contacts the touchscreen is referred to as "contact touch" for convenience of description. A position at which proximity touch of the pointer is performed on the touchscreen is a position at which the pointer corresponds perpendicularly to the touchscreen when the proximity touch of the pointer is performed.

The proximity sensor 141 senses a proximity touch operation and proximity touch patterns (for example, a proximity touch distance, a proximity touch direction, proximity touch velocity, proximity touch time, a proximity touch position, proximity touch movement, etc.) Information corresponding to the sensed proximity touch operation and proximity touch patterns may be output on the touchscreen.

The sound output module 152 may output audio data which has been received from the wireless communication unit 110 or has been stored in the memory 160 during a call signal reception mode, a call connection mode, a recording mode, a voice recognition mode, a broadcast reception mode, and the like. The sound output module 152 may output sound signals related to functions (e.g., call signal reception sound, message reception sound, etc.) carried out in the portable device 100. The sound output module 152 may include a receiver, a speaker, a buzzer, and the like.

The alarm unit 153 outputs a signal notifying the user that an event has occurred in the portable device 100. Examples of the event occurring in the portable device 100 include incoming call reception, message reception, key signal input, touch input, etc. The alarm unit 153 outputs a signal notifying the user of the occurrence of an event in a different form from an audio signal or a video signal. For example, the alarm unit 153 may output a notification signal through vibration. The video signal or the audio signal may be output through the sound output module 152, so that the display unit 151 and the sound output module 152 may be classified as some parts of the alarm unit 153.

The haptic module 154 generates a variety of tactile effects which the user can sense. One typical example of the tactile effects that can be generated by the haptic module 154 is vibration. In a case where the haptic module 154 generates vibration as a tactile effect, the haptic module 154 may change intensity and pattern of generated vibration. For example, the haptic module 154 may combine different vibrations and output the combined vibration, or may sequentially output different vibrations.

In addition to vibration, the haptic module 154 may generate various tactile effects, such as a stimulus effect by an arrangement of pins that move perpendicularly to the touched skin surface, a stimulus effect by air blowing or suction through an air outlet or inlet, a stimulus effect through brushing of the skin surface, a stimulus effect through contact with an electrode, a stimulus effect using electrostatic force, and a stimulus effect through reproduction of thermal (cool/warm) sensation using an endothermic or exothermic element.

The haptic module 154 may be implemented so as to allow the user to perceive such effects not only through direct tactile sensation but also through kinesthetic sensation of fingers, arms, or the like of the user. Two or more haptic modules 154 may be provided depending on how the portable device 100 is constructed.

The memory 160 may store a program for operating the controller 180, and may temporarily store I/O data (for example, a phonebook, a message, a still image, a moving image, etc.). The memory 160 may store vibration and sound data of various patterns that are output when a user touches the touchscreen.

The memory 160 may include a storage medium of at least one type of a flash memory, a hard disk, a multimedia card micro type, a card type memory (for example, SD or XD memory), a Random Access Memory (RAM), a Static Random Access Memory (SRAM), a Read-Only Memory (ROM), an Electrically Erasable Programmable Read-Only Memory (EEPROM), a Programmable Read-Only Memory (PROM), a magnetic memory, a magnetic disc, an optical disc, etc. Also, the portable device 100 may utilize web storage that performs a storage function of the memory 160 over the Internet.

The interface unit 170 may be used as a path via which the portable device 100 is connected to all external devices. The interface unit 170 receives data from the external devices, or receives a power-supply signal from the external devices, such that it transmits the received data and the power-supply signal to each constituent element contained in the portable device 100, or transmits data stored in the portable device 100 to the external devices. For example, the interface unit 170 may include a wired/wireless headset port, an external charger port, a wired/wireless data port, a memory card port, a port connected to a device including an identification module, an audio I/O port, a video I/O port, an earphone port, and the like.

An identification module is a chip that stores a variety of information for identifying the authority to use the portable device 100, and may include a user identity module (UIM), a subscriber identity module (SIM), a universal scriber identity module (USIM), and the like. A device including an identification (ID) module (hereinafter referred to as an identification device) may be configured in the form of a smart card. Therefore, the ID device may be coupled to the portable device 100 through a port.

When the portable device 100 is connected to an external cradle, the interface unit 170 may be used as a path through which the connected cradle supplies power to the portable device 100 or a path through which a variety of command signals input to the cradle by a user are transferred to the portable device 100. The various command signals or the power input from the cradle may function as a signal for enabling the user to perceive that the mobile terminal is correctly mounted in the cradle.

The controller 180 generally controls the overall operation of the portable device 100. For example, the controller 180 performs control and processing associated with voice communication, data communication, video communication, and the like. The controller 180 may include a multimedia module 181 for multimedia reproduction. The multimedia module 181 may be installed at the interior or exterior of the controller 180.

The controller 180 may sense a user action and control the portable device 100 based on the sensed user action. The user action may include selection of a physical button of a display or a remote controller, implementation of a prescribed touch gesture or selection of a soft button on a touchscreen display, implementation of a prescribed spatial gesture recognized from an image captured from a capture device, and implementation of prescribed speaking recognized through voice recognition with respect to a voice signal received by the microphone 122. The controller 180 may interpret the user action as at least one implementable command. The controller 180 may control the components of the electronic device 400 in response to the at least one interpreted command. That is, the controller 180 may control input and output between the components of the portable device 100 and reception and processing of data, using the at least one command.

The controller 180 can perform pattern recognition processing so as to recognize handwriting input or drawing input performed on the touchscreen as text and images.

The power supply unit 190 serves to supply power to each component by receiving external power or internal power under control of the controller 180.

A variety of embodiments to be disclosed in the following description may be implemented in a computer or a computer-readable recording medium by means of software, hardware, or a combination thereof.

In the case of implementing the present invention by hardware, the embodiments of the present invention may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, and electric units for implementing other functions, etc. In some cases, embodiments of the present invention may also be implemented as the controller 180.

In the case of implementing the present invention by software, embodiments such as steps and functions to be disclosed in the present invention can be implemented by additional software modules. Each software module may perform one or more functions and operations to be disclosed in the present invention. Software code can be implemented as a software application written in suitable program languages. The software code may be stored in the memory 160, and may be carried out by the controller 180.

The present invention is aimed to always drive a haptic actuator at a resonant frequency for generating the maximum vibration by tracing a resonance point using a back (or counter) electromotive force (EMF) in the portable device (or terminal) of FIG. 1. Specifically, the present invention is aimed to always drive a haptic actuator at a resonant frequency for generating the maximum vibration by tracing and compensating the resonant frequency even when the resonant frequency is changed due to system aging, physical impact, mass variation, or the like.

In addition, the present invention is aimed to rapidly stop vibration by controlling residual vibration using a back EMF (or a back EMF signal).

According to an embodiment of the present invention, a haptic actuator 155 may be included in the haptic module 154 of FIG. 1.

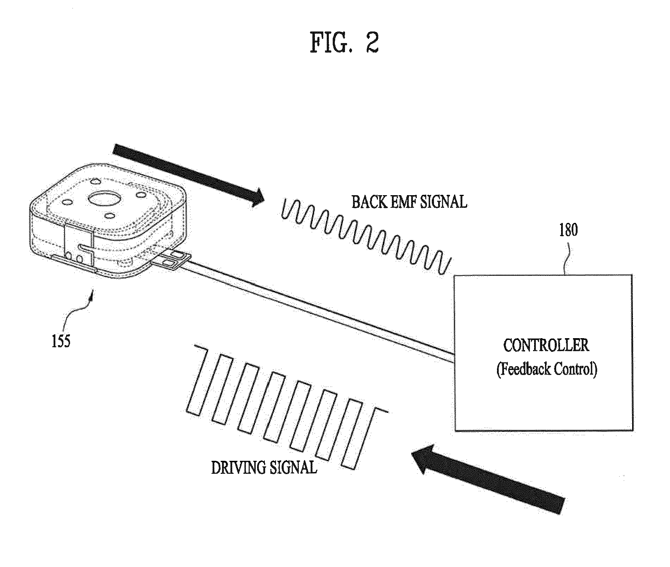

FIG. 2 is a block diagram of a vibration generating apparatus according to an embodiment of the present invention, and the vibration generating apparatus may include, for example, a controller 180 and the haptic actuator 155. In this case, the controller 180 may include a driver for providing a driving signal to the haptic actuator 155, and a back EMF detector for detecting a back EMF signal fed back from the haptic actuator 155. The driver and the back EMF detector may be included in the haptic module 154, or may be provided separately from the controller 180 and the haptic module 154.

The controller 180 of FIG. 2 provides a driving signal to the haptic actuator 155. The haptic actuator 155 generates vibration based on the driving signal, and this vibration is transmitted to the display 151. If power supply from the controller 180 is cut off and thus high impedance state is made, the haptic actuator 155 generates and feeds back a back EMF signal to the controller 180. The controller 180 controls (compensates) the driving signal using the back EMF signal. Here, the driving signal may also be called a driving voltage and may have, for example, a form of pulses. A single-cycle pulse is inversely proportional to a frequency. That is, a repetition of a certain state whenever a certain period passes is generally called a periodic change, and a period required to return to the same state is called a cycle. A frequency means the number of vibrations and is expressed as an inverse number (=1/T) of the cycle (=T). The back EMF signal is also called a back EMF and may have, for example, a waveform.

FIG. 2 shows that the driving signal and the back EMF signal are transmitted using a single line. That is, the controller 180 provides the driving signal to the haptic actuator 155 through a line, and the back EMF signal is fed back to the controller 180 through the line in high impedance state. Therefore, control of two signals using one connected port is enabled. This means that a resonance point may be traced without using an additional sensor such as an acceleration sensor.

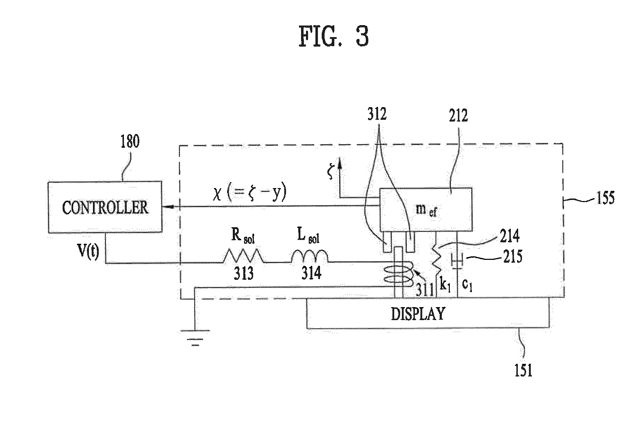

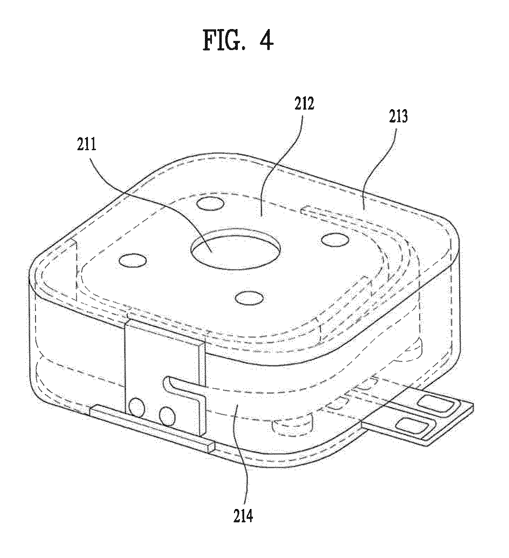

FIG. 3 is a circuit diagram of the vibration generating apparatus according to an embodiment of the present invention, and FIG. 4 is a perspective view of the haptic actuator 155 according to an embodiment of the present invention.

Referring to FIGS. 2 to 4, the haptic actuator 155 includes an electromagnetic force generator 211 for generating an electromagnetic force by receiving a driving voltage, i.e., a pulse-type driving signal, an elastic body 214 elastically moving due to the electromagnetic force, a vibrator 212 vibrating in a certain direction due to the elastic motion of the elastic body 214, and a transmitting member 213 for transmitting the vibration of the vibrator 212 to the display 151.

The electromagnetic force generator 211 generates an electromagnetic force by receiving a driving voltage. In addition, if the driving voltage is cut off and thus high impedance state is made, the electromagnetic force generator 211 generates and feeds back a back EMF to the controller 180.

According to an embodiment of the present invention, the haptic actuator 155 may be a coil-based actuator.

To this end, the electromagnetic force generator 211 includes a coil 311 through which a current flows due to the driving voltage, and a magnetic body 312 for forming a magnetic field to generate the Lorentz force by interacting with the current. The electromagnetic force generator 211 may include a resistor 313 and an inductor 314 connected in serial between a driver 161 and the coil 311.

That is, the current generated due to the driving voltage applied from the controller 180 is applied through the resistor 313 and the inductor 314 to the coil 311. Then, the Lorentz force is generated due to interaction between the current flowing through the coil 311 and the magnetic field formed by the magnetic body 312 located near the coil 311, and the vibrator 212 vibrates using the generated Lorentz force as an external force.

According to an embodiment of the present invention, one of the coil 311 and the magnetic body 312 may be mounted on the vibrator 212, and the other may be mounted on the transmitting member 213.

Although the magnetic body 312 is mounted on the vibrator 212 and the coil 311 is mounted on the transmitting member 213 in FIG. 3, the present invention is not limited thereto, and the coil 311 may be mounted on the vibrator 212 and the magnetic body 312 may be mounted on the transmitting member 213. According to another embodiment, one of the coil 311 and the magnetic body 312 may be inserted into the vibrator 212.

The haptic actuator 155 according to the present invention may further include a damper 215. The damper 215 is provided between the vibrator 212 and the transmitting member 213 to reduce a deviation of vibration generated by the haptic actuator 155. In general, the vibration generated by the haptic actuator 155 due to a change in contact pressure of the display 151 exhibits the highest level at a resonant frequency and exhibits a low level at the other frequencies. Accordingly, the damper 215 reduces the high vibration level at the resonant frequency through damping, and increases the low vibration level at the other frequencies, thereby reducing the deviation between the vibration levels. In addition, the damper 215 is a material having a damping factor sufficiently low not to excessively reduce the vibration and a spring constant capable of properly transmitting the vibration. The material of the damper 215 may include at least one of rubber and sponge. However, the material is not limited thereto and is variable within a range understood by one of ordinary skill in the art.

The vibrator 212 is adhered to an end part of the elastic body 214 and vibrates. That is, the vibrator 212 serves as a mass for vibration using the elastic body 214, and the level, frequency, etc. of generated vibration may be adjusted based on the mass, shape, etc. of the vibrator 212.

The transmitting member 213 transmits the vibration generated by the vibrator 212, to the display 151. According to an embodiment, the transmitting member 213 may be configured as a case including the electromagnetic force generator 211, the vibrator 212, and the elastic body 214.

The elastic body 214 may be a leaf spring having a certain elastic modulus and interconnecting the vibrator 212 and the transmitting member 213. In this case, the elastic body 214 may have one end connected to the vibrator 212 and another end connected to the transmitting member 213 and thus may transmit the vibration of the vibrator 212 to the transmitting member 213, and may elastically move while being supported by the transmitting member 213.

A voltage V(t) applied to the coil-based haptic actuator 155 configured as described above, to drive the haptic actuator 155 is as given by Equation 1.

[Equation 1]

$$V(t) = Ri(t) + v_b(t) + L\frac{di(t)}{dt}$$

A back EMF $v_b(t)$ of Equation 1 is as given by Equation 2.

[Equation 2]

$$v_b(t) = K_{bemf} \bullet x'$$

Equation 1 shows that the back EMF signal $V_b(t)$ is detected in high impedance state. Here, x' denotes the moving speed of the vibrator 212 and is proportional to the back EMF signal $V_b(t)$.

Since the back EMF signal $V_b(t)$ of Equation 1 corresponds to a differential value of the displacement (i.e., motion) of the vibrator 212, the displacement of the vibrator 212 is predictable. That is, since the back EMF is proportional to the speed of the vibrator 212, the present invention is aimed to trace a resonance point by controlling the location of the vibrator 212, i.e., the speed of the vibrator 212.

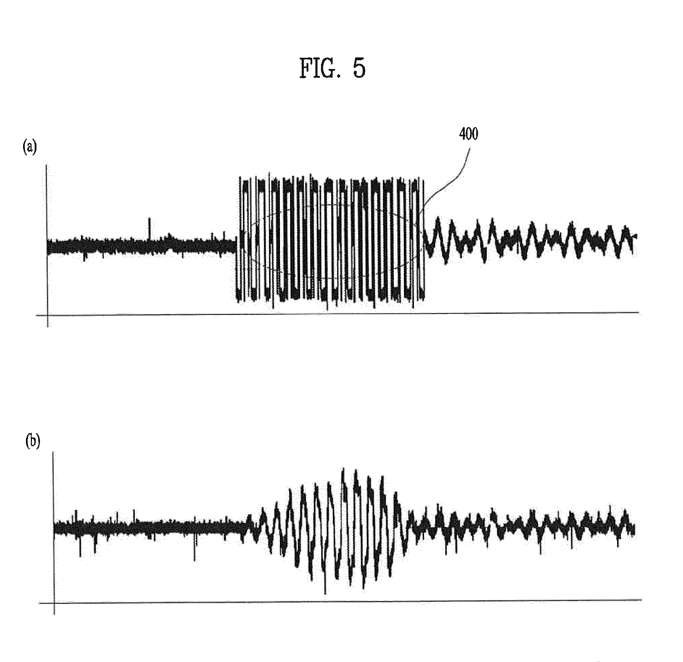

FIG. 5(a) shows an example in which a driving signal and a back EMF signal 400 are generated in a single line, and the back EMF signal 400 is within the driving signal corresponding to a group of unidirectional pulses. Here, the unidirectional pulse means a half-cycle pulse and is a high-direction pulse or a low-direction pulse.

FIG. 5(b) comparatively shows an example of a signal detected from an acceleration sensor, and shows that this signal has a form very similar to that of the back EMF signal 400 according to the present invention. In this case, a phase difference may be present.

The present invention is aimed to always drive a haptic actuator at a resonant frequency for generating the maximum vibration by tracing a resonance point, which is changed due to an internal/external factor, e.g., system aging, physical impact, mass variation, or the like, using a back EMF signal in every driving operation.

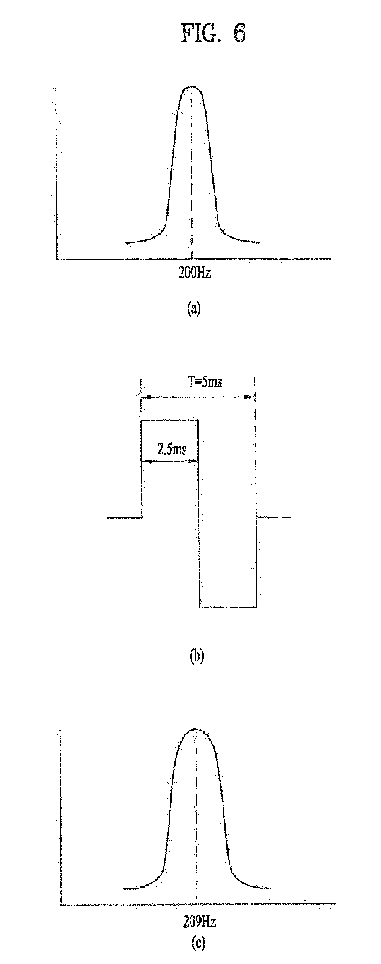

FIG. 6(a) shows an example of a preset resonant frequency, and the resonant frequency is assumed as 200 Hz. If the resonant frequency of 200 Hz is converted into a single-cycle pulse, the pulse corresponds to 5 ms as shown in FIG. 6(b). Then, a period (i.e., a duration) of a half-cycle pulse, i.e., a high pulse or a low pulse, is 2.5 ms. The half-cycle pulse is called a unidirectional pulse in the present invention.

On the assumption that the resonant frequency is changed to 209 Hz as shown in FIG. 6(c) due to an internal/external factor, the present invention describes a process for detecting and tracing the changed resonant frequency.

To this end, the controller 180 according to the present invention generates a unidirectional pulse based on a preset resonant frequency, applies the unidirectional pulse to the haptic actuator 155, and then cuts off power supply to make high impedance state of the haptic actuator 155. In this case, the controller 180 generates an opposite-direction pulse using a back EMF signal fed back from the haptic actuator 155 and applies the opposite-direction pulse to the haptic actuator 155. This process is repeated for a desired duration of vibration. That is, the controller 180 adjusts the driving signal applied to the haptic actuator 155, based on the back EMF signal. In other words, the controller 180 adjusts a start timing of the unidirectional pulse applied to the haptic actuator 155. The desired duration of vibration may be preliminarily determined when the system is designed, or may be selected by a user.

Here, a period of the unidirectional pulse applied to the haptic actuator 155 (i.e., a duration of a unidirectional pulse corresponding to a half of a single-cycle pulse) may be set, for example, to be less than the period of the unidirectional pulse corresponding to the preset resonant frequency. That is, if it is assume that the preset resonant frequency is 200 Hz, the period of the unidirectional pulse applied to the haptic actuator 155 may be set to be less than 2.5 ms. For example, the period may be set to 2.2 ms to 2.4 ms. This is because the back EMF signal is not seen due to the unidirectional pulse if the period of the unidirectional pulse applied to the haptic actuator 155 is greater than the period of the unidirectional pulse corresponding to the preset resonant frequency.

According to an embodiment of the present invention, the opposite-direction pulse may be generated and applied when a zero crossing point of the back EMF signal is detected. That is, the opposite-direction pulse is generated and applied to the haptic actuator 155 at the zero crossing point of the back EMF signal. According to another embodiment, the opposite-direction pulse may be generated and applied to the haptic actuator 155 at an extreme point of the back EMF signal.

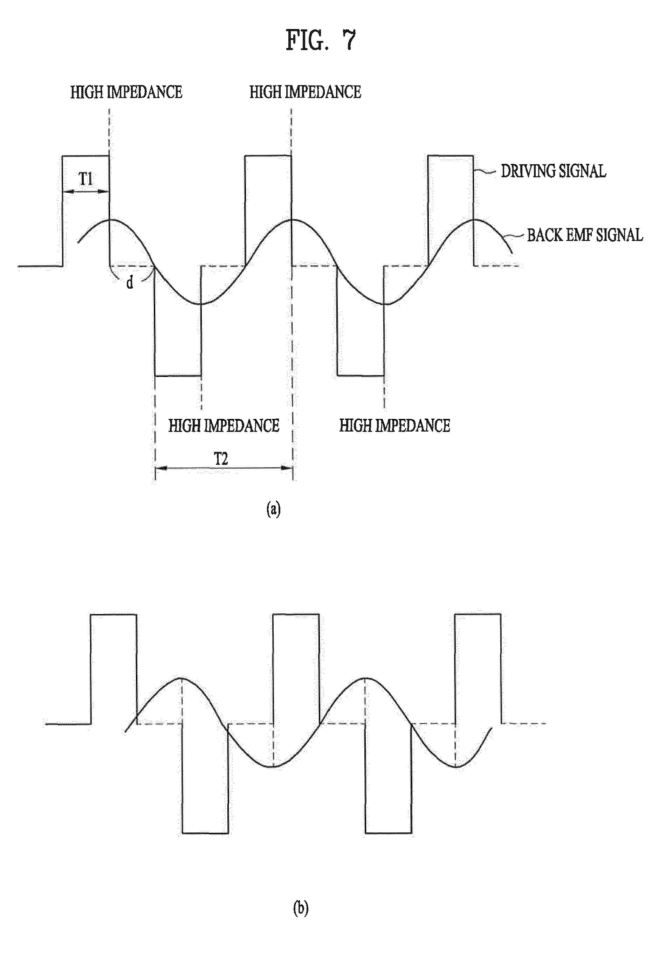

FIG. 7(a) illustrates a waveform showing an example in which a driving signal is generated and applied to the haptic actuator 155 at zero crossing points of a back EMF signal on a half-cycle pulse basis. In this case, it is assumed that a resonant frequency is changed from 200 Hz to 209 Hz.

That is, if a unidirectional (i.e., high-direction) pulse is applied to the haptic actuator 155 and then power supply is cut off, high impedance state is made and a back EMF signal is fed back. Then, a zero crossing point of the back EMF signal which is fed back is detected, and an opposite-direction (i.e., low-direction) pulse is generated and applied to the haptic actuator 155 at the zero crossing point. In this case, a period T1 of the high-direction pulse and the low-direction pulse is assumed as 2.3 ms. Then, it is noted that a delay time corresponding to 'd' is generated after the high-direction pulse is applied until the zero crossing point of the back EMF signal is detected. That is, the delay time corresponding to 'd' is generated after the high-direction pulse is finished until the low-direction pulse is generated. After this process is completed, a single-cycle pulse has been applied to the haptic actuator 155 and a period of a single cycle in this case is about 0.478 ms. If this period is converted to a frequency, the frequency is 209 Hz. That is, the zero crossing point of the back EMF signal is a resonance point. This process is repeated for a desired duration of vibration, and the haptic actuator 155 vibrates according to the resonant frequency of 209 Hz.

FIG. 7(b) illustrates a waveform showing an example in which a driving signal is generated and applied to the haptic actuator 155 at extreme points (i.e., peak points) of a back EMF signal on a half-cycle pulse basis. A description of this example is the same as that of the example of FIG. 7(a) except that reference points for generating opposite-direction pulses are not the zero crossing points but the extreme points of the back EMF signal.

As described above, according to the present invention, even when a resonant frequency is changed due to an internal/external factor, the changed resonant frequency is detected and a haptic actuator is driven due to the detected resonant frequency. Meanwhile, even when a desired duration of vibration has passed and thus vibration operation is terminated, continuation of vibration of the haptic actuator, i.e., residual vibration, occurs due to physical properties of the haptic actuator. This residual vibration phenomenon may basically reduce the life of the haptic actuator and may cause phantom vibration syndrome to a user.

To solve this, according to an embodiment of the present invention, a back EMF may be used. That is, the controller 180 controls residual vibration by generating a residual vibration control signal (i.e., a unidirectional pulse and an opposite-direction pulse) based on a back EMF signal similarly to the method for controlling the driving signal of the haptic actuator 155. This process is continued until the amplitude of the back EMF signal is equal to or less than a certain value. As such, undesired residual vibration which cannot be easily solved in a mechanical manner may be eliminated. For example, residual vibration may be reduced by 85% or more.

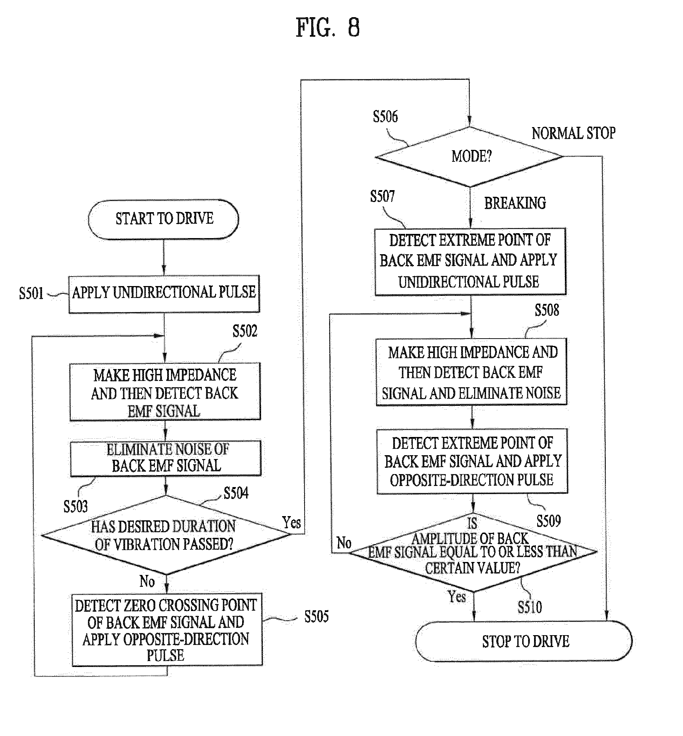

FIG. 8 is a flowchart of a vibration generating method according to an embodiment of the present invention, and shows an example of controlling a driving signal and residual vibration of the haptic actuator 155 using a back EMF.

That is, when driving is started, the controller 180 applies a unidirectional pulse generated based on a preset resonant frequency, to the haptic actuator 155 (S501). Here, a period of the unidirectional pulse may be, for example, less than a period of a unidirectional pulse corresponding to the preset resonant frequency. After the unidirectional pulse is applied to the haptic actuator 155 in step S501, the controller 180 makes high impedance state of the haptic actuator 155 by blocking a driving voltage applied to the haptic actuator 155. Then, the haptic actuator 155 generates and feeds back a back EMF signal to the controller 180. The controller 180 detects the back EMF signal which is fed back (S502), and eliminates noise from the detected back EMF signal (S503). For example, the noise of the back EMF signal may be eliminated using a low pass filter (LPF). That is, if the back EMF signal is LPF-filtered, high-frequency components included in the back EMF signal are eliminated and thus the noise included in the back EMF signal is eliminated.

After that, it is determined whether a desired duration of vibration has passed (S504). If the desired duration of vibration has not passed, an opposite-direction pulse is generated and applied to the haptic actuator 155 at a zero crossing point of the noise-eliminated back EMF signal (S505). A period of the opposite-direction pulse is the same as the period of the unidirectional pulse. In addition, the opposite-direction pulse is a low-direction pulse if the unidirectional pulse is a high-direction pulse, or is a high-direction pulse if the unidirectional pulse is a low-direction pulse. The direction of the opposite-direction pulse applied whenever step S505 is performed is switched to an opposite direction within the desired duration of vibration. For example, if the opposite-direction pulse is a low-direction pulse when step S505 is performed first, the opposite-direction pulse is a high-direction pulse opposite to the low-direction pulse when step S505 is performed next.

After step S505 is performed, the method returns to step S502 and the controller 180 makes high impedance state of the haptic actuator 155 by blocking the driving voltage applied to the haptic actuator 155 and then detects the back EMF signal. The subsequent processes are repeated until the desired duration of vibration has passed. That is, a low pulse and a high pulse are alternately applied to the haptic actuator 155 until the desired duration of vibration has passed. In this case, a start timing of the low pulse or the high pulse may be a zero crossing point or an extreme point of the back EMF signal.

If the desired duration of vibration has passed in step S504, it is determined whether a current mode is a normal stop mode or a breaking mode (S506).

Here, the normal stop mode means that driving of the haptic actuator 155 is terminated without controlling residual vibration, and the breaking mode means that driving of the haptic actuator 155 is terminated while controlling residual vibration.

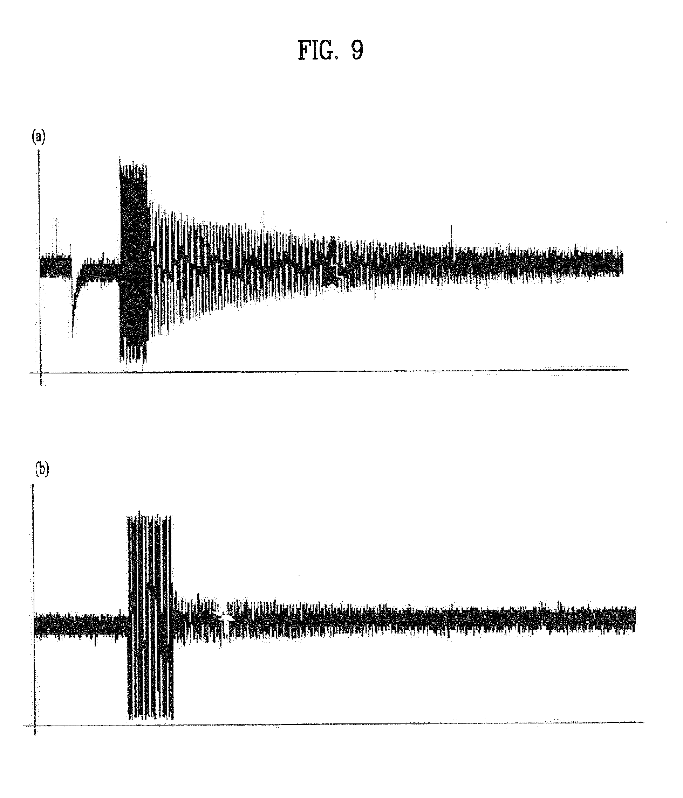

If the normal stop mode is determined in step S506, driving of the haptic actuator 155 is terminated by blocking the driving voltage applied to the haptic actuator 155. In this case, continuation of vibration of the haptic actuator 155, i.e., residual vibration, occurs due to physical properties of the haptic actuator 155 as shown in FIG. 9(a).

If the breaking mode is determined in step S506, an extreme point of the back EMF signal from which the noise is eliminated in step S503 is detected, and a residual vibration control signal of a unidirectional pulse is generated and applied to the haptic actuator 155 at the detected extreme point of the back EMF signal (S507).

The direction of a half-cycle pulse generated in step S507 is the same as the direction of a half-cycle pulse generated as a driving signal immediately before step S504. For example, if a half-cycle pulse applied as the last driving signal is a high-direction pulse, a first half-cycle pulse of the residual vibration control signal applied to control residual vibration in step S507 is also a high-direction pulse.

After the unidirectional pulse is applied to the haptic actuator 155 to control residual vibration in step S507, the controller 180 makes high impedance state of the haptic actuator 155 by blocking the driving voltage again, detects the back EMF signal which is fed back in this case, and eliminates noise therefrom (S508). For example, the noise of the back EMF signal may be eliminated using a LPF as described above in step S503.

An extreme point is detected from the back EMF signal from which the noise is eliminated in step S508, and an opposite-direction pulse is generated and applied to the haptic actuator 155 at the detected extreme point (S509). It is determined whether the amplitude of the noise-eliminated back EMF signal is equal to or less than a certain value (S510).

The direction of the opposite-direction pulse applied whenever step S509 is performed is switched to an opposite direction until the amplitude of the back EMF signal is equal to or less than the certain value. For example, if the opposite-direction pulse is a low-direction pulse when step S509 is performed first, the opposite-direction pulse is a high-direction pulse opposite to the low-direction pulse when step S509 is performed next.

If the amplitude of the back EMF signal is not equal to or less than the certain value in step S510, the method returns to step S508 and the above steps are repeated. If the amplitude of the back EMF signal is equal to or less than the certain value, the process of generating and applying a half-cycle pulse is terminated.

As such, undesired residual vibration which cannot be easily solved in a mechanical manner may be eliminated as shown in FIG. 9(b). FIG. 9(b) shows that residual vibration is reduced by 85% or more compared to FIG. 9(a).

The present invention is also applicable to a multi-resonant actuator which vibrates at multiple resonant frequencies.

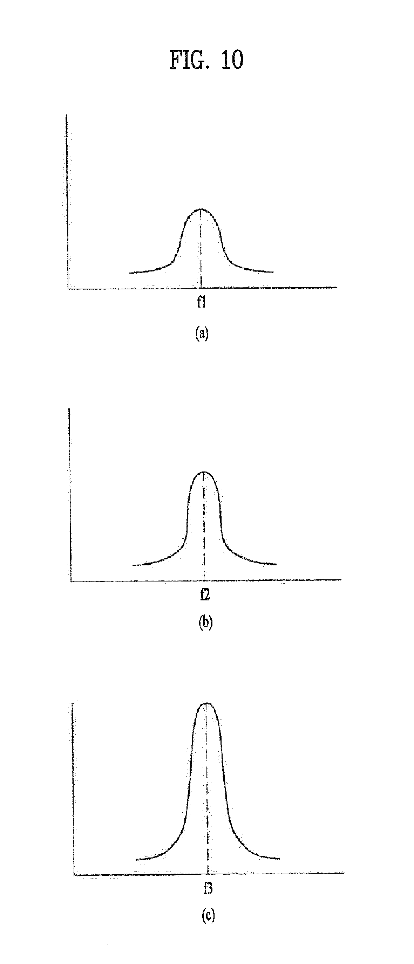

FIGs. 10(a) to 10(c) show an example of multiple resonant frequencies. For example, a resonant frequency f1 shown in FIG. 10(a) is 50 Hz, a resonant frequency f2 shown in FIG. 10(b) is 150 Hz, and a resonant frequency f3 shown in FIG. 10(c) is 200 Hz. That is, the haptic actuator 155 may vibrate with a resonant frequency of 50 Hz or 200 Hz. The number and values of resonant frequencies capable of allowing the haptic actuator 155 to vibrate may be changed based on the haptic actuator 155, and thus the present invention is not limited to the above embodiment.

Even in this case, a period (i.e., a duration) of a unidirectional (i.e., half-cycle) pulse applied to the haptic actuator 155 is set to be less than a period (i.e., a duration) of a unidirectional pulse corresponding to each of the resonant frequencies of FIGS. 10(a) to 10(c). For example, when the haptic actuator 155 is driven with a resonant frequency of 50 Hz, a period of a unidirectional pulse applied to detect and trace the resonant frequency is set to be less than a period of a unidirectional pulse corresponding to 50 Hz, e.g., 10 ms.

At this time, for example, a driving signal may be controlled by detecting a zero crossing point of a back EMF signal and residual vibration may be controlled by detecting an extreme point of the back EMF signal. Alternatively, a driving signal may be controlled by detecting an extreme point of a back EMF signal and residual vibration may be controlled by detecting a zero crossing point of the back EMF signal. According to another embodiment, both a driving signal and residual vibration may be controlled by detecting a zero crossing point of a back EMF signal or by detecting an extreme point of the back EMF signal.

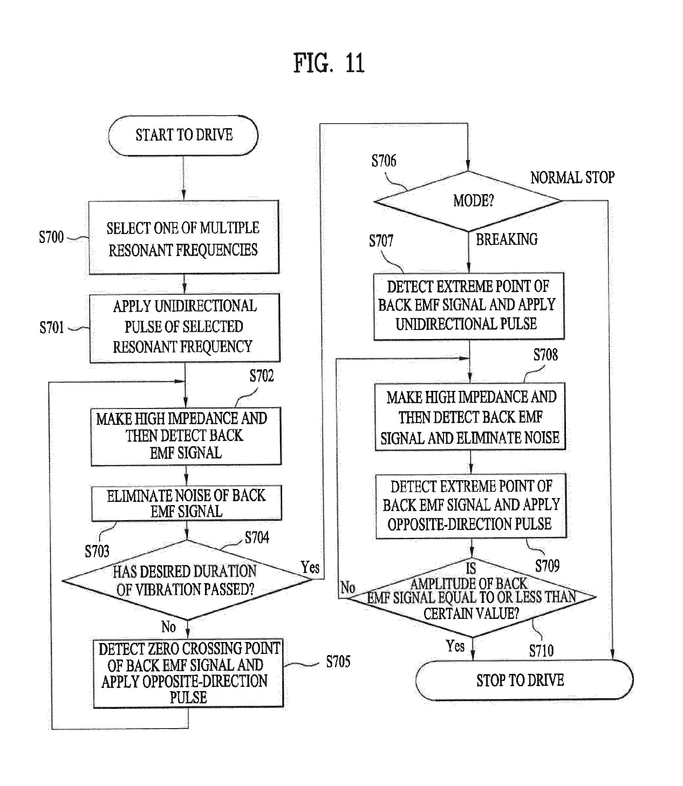

FIG. 11 is a flowchart of a vibration generating method of a multi-resonant haptic actuator according to an embodiment of the present invention.

Initially, one of multiple resonant frequencies is selected (S700). The resonant frequency may be automatically selected by a system, or selected by a user. For example, it is assumed that the resonant frequency of 200 Hz shown in FIG. 10(c) is selected.

Then, the controller 180 applies a unidirectional pulse generated based on the resonant frequency of 200 Hz, to the haptic actuator 155 (S701). In this case, since a period of a unidirectional pulse corresponding to the resonant frequency of 200 Hz is 2.5 ms, a period of the unidirectional pulse applied to the haptic actuator 155 in step S701 may be set to be less than 2.5 ms. For example, the period of the unidirectional pulse applied to the haptic actuator 155 in step S701 may be 2.3 ms. Here, the unidirectional pulse may be a high-direction pulse or a low-direction pulse.

After the unidirectional pulse is applied to the haptic actuator 155 in step S701, the controller 180 blocks a driving voltage applied to the haptic actuator 155 and thus makes high impedance state of the haptic actuator 155. Then, the haptic actuator 155 generates and feeds back a back EMF signal to the controller 180. The controller 180 detects the back EMF signal which is fed back (S702), and eliminates noise from the detected back EMF signal (S703). For example, the noise of the back EMF signal may be eliminated using a LPF. That is, if the back EMF signal is LPF-filtered, high-frequency components included in the back EMF signal are eliminated and thus the noise included in the back EMF signal is eliminated.

After that, it is determined whether a desired duration of vibration has passed (S704). If the desired duration of vibration has not passed, an opposite-direction pulse is generated and applied to the haptic actuator 155 at a zero crossing point of the noise-eliminated back EMF signal (S705). A period of the opposite-direction pulse is the same as the period of the unidirectional pulse. In addition, the opposite-direction pulse is a low-direction pulse if the unidirectional pulse is a high-direction pulse, or is a high-direction pulse if the unidirectional pulse is a low-direction pulse. If step S705 is performed two or more times, the direction of the opposite-direction pulse is switched to an opposite direction whenever step S705 is performed.

After step S705 is performed, the method returns to step S702 and the controller 180 makes high impedance state of the haptic actuator 155 by blocking the driving voltage applied to the haptic actuator 155 and then detects the back EMF signal. The subsequent processes are repeated until the desired duration of vibration has passed.

If the desired duration of vibration has passed in step S704, it is determined whether a current mode is a normal stop mode or a breaking mode (S706).

If the normal stop mode is determined in step S706, driving of the haptic actuator 155 is terminated by blocking the driving voltage applied to the haptic actuator 155.

If the breaking mode is determined in step S706, an extreme point of the back EMF signal from which the noise is eliminated in step S703 is detected, and a unidirectional pulse is generated and applied to the haptic actuator 155 at the detected extreme point of the back EMF signal (S707).

The direction of a half-cycle pulse generated in step S707 is the same as the direction of a half-cycle pulse generated as a driving signal immediately before step S704. For example, if a half-cycle pulse applied as the last driving signal is a high-direction pulse, a half-cycle pulse applied to control residual vibration in step S707 is also a high-direction pulse.

After the unidirectional pulse is applied to the haptic actuator 155 to control residual vibration in step S707, the controller 180 makes high impedance state of the haptic actuator 155 by blocking the driving voltage again, detects the back EMF signal which is fed back in this case, and eliminates noise therefrom (S708). For example, the noise of the back EMF signal may be eliminated using a LPF as described above in step S703.

An extreme point is detected from the back EMF signal from which the noise is eliminated in step S708, and an opposite-direction pulse is generated and applied to the haptic actuator 155 at the detected extreme point (S709). It is determined whether the amplitude of the noise-eliminated back EMF signal is equal to or less than a certain value (S710).

If the amplitude of the back EMF signal is not equal to or less than the certain value in step S710, the method returns to step S708 and the above steps are repeated. If the amplitude of the back EMF signal is equal to or less than the certain value, the process of generating and applying a unidirectional pulse is terminated.

As such, undesired residual vibration which cannot be easily solved in a mechanical manner may be eliminated.

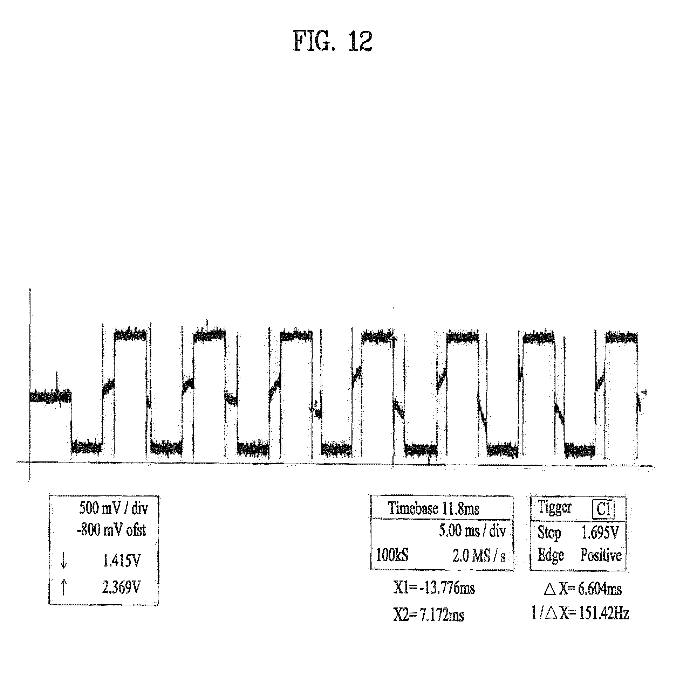

FIG. 12 illustrates a waveform showing an example in which, when a resonant frequency selected among multiple resonant frequencies is 150 Hz, the haptic actuator 155 is driven by tracing a resonance point using a back EMF signal and thus is driven with a resonant frequency which is changed due to an internal/external factor. FIG. 12 shows that the resonant frequency is changed to 151.42 Hz and a driving signal of the haptic actuator 155 is controlled to trace the changed resonant frequency (i.e., 151.42 Hz).

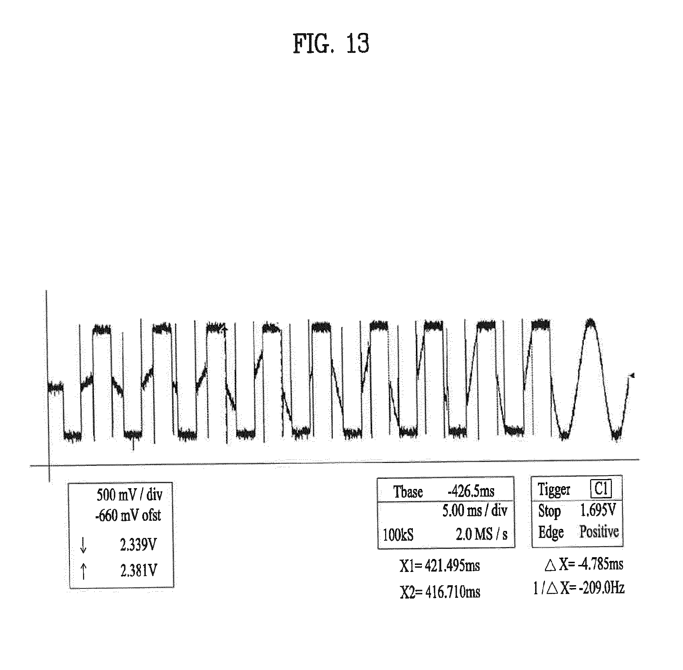

FIG. 13 illustrates a waveform showing an example in which, when a resonant frequency selected among multiple resonant frequencies is 200 Hz, the haptic actuator 155 is driven by tracing a resonance point using a back EMF signal and thus is driven with a resonant frequency which is changed due to an internal/external factor. FIG. 13 shows that the resonant frequency is changed to 209 Hz and a driving signal of the haptic actuator 155 is controlled to trace the changed resonant frequency (i.e., 209 Hz).

According to the above-described embodiment of the present invention, a driving signal is controlled based on a zero crossing point of a back EMF signal and residual vibration is controlled based on an extreme point of the back EMF signal. However, the above embodiment is merely exemplary, and a driving signal may be controlled based on an extreme point of a back EMF signal and residual vibration may be controlled based on a zero crossing point of the back EMF signal. According to another embodiment of the present invention, both a driving signal and residual vibration may be controlled based on a zero crossing point of a back EMF signal or based on an extreme point of the back EMF signal.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

[Mode for Invention]

Various embodiments have been described in the best mode for carrying out the invention.

[Industrial Applicability]

As described above, the present invention is applicable to all vibration generating apparatuses.

**Claims**

1. A vibration generating apparatus comprising:

   a haptic actuator for generating vibrations by driving according to a driving signal; and
   a controller for applying the driving signal of a half-cycle pulse to the haptic actuator, making high impedance state of the haptic actuator, and then controlling a start timing of a subsequent half-cycle pulse of the driving signal to be applied to the haptic actuator based on a back electromotive force (EMF) signal generated by the haptic actuator,
   wherein the applying, the making, and the controlling are repeated for a desired duration of vibration, and
   wherein a direction of the half-cycle pulse is switched to an opposite direction whenever the driving signal of the half-cycle pulse is applied to the haptic actuator.

2. The vibration generating apparatus according to claim 1, wherein a period of the half-cycle pulse of the driving signal is set to be less than a period of a half-cycle pulse corresponding to a preset resonant frequency.

3. The vibration generating apparatus according to claim 1, wherein the controller determines a zero crossing point of the back EMF signal as the start timing of the half-cycle pulse of the driving signal.

**4.** The vibration generating apparatus according to claim 1, wherein the controller determines an extreme point of the back EMF signal as the start timing of the half-cycle pulse of the driving signal.

**5.** The vibration generating apparatus according to claim 1, wherein the controller generates a residual vibration control signal based on the back EMF signal generated by the haptic actuator and applies the generated residual vibration control signal to the haptic actuator, if the desired duration of vibration has passed.

**6.** The vibration generating apparatus according to claim 5, wherein the residual vibration control signal is applied to the haptic actuator on a half-cycle pulse basis, and

wherein a direction of an initial half-cycle pulse of the residual vibration control signal is the same as a direction of a last half-cycle pulse of the driving signal.

**7.** The vibration generating apparatus according to claim 6, wherein a period of the half-cycle pulse of the driving signal is the same as a period of a half-cycle pulse of the residual vibration control signal.

**8.** The vibration generating apparatus according to claim 6, wherein the controller determines a zero crossing point of the back EMF signal as a start timing of a half-cycle pulse of the residual vibration control signal.

**9.** The vibration generating apparatus according to claim 6, wherein the controller determines an extreme point of the back EMF signal as a start timing of a half-cycle pulse of the residual vibration control signal.

**10.** The vibration generating apparatus according to claim 1, wherein a line for applying the driving signal is the same as a line for feeding back the back EMF signal.

**11.** A vibration generating method for generating vibrations by driving a haptic actuator, the method comprising:

applying a driving signal of a half-cycle pulse to the haptic actuator and making high impedance state of the haptic actuator;
detecting a back electromotive force (EMF) signal generated in the high impedance state by the haptic actuator;
determining a start timing of a subsequent half-cycle pulse of the driving signal to be applied to the haptic actuator based on the detected back EMF signal; and

applying the half-cycle pulse of the driving signal to the haptic actuator at the determined start timing,
wherein the applying and making, the detecting, and the determining and applying are repeated for a desired duration of vibration, and
wherein a direction of the half-cycle pulse is switched to an opposite direction whenever the driving signal of the half-cycle pulse is applied to the haptic actuator.

**12.** The vibration generating method according to claim 11, wherein a period of the half-cycle pulse of the driving signal is set to be less than a period of a half-cycle pulse corresponding to a preset resonant frequency.

**13.** The vibration generating method according to claim 11, wherein a zero crossing point of the back EMF signal is determined as the start timing of the half-cycle pulse of the driving signal.

**14.** The vibration generating method according to claim 11, wherein an extreme point of the back EMF signal is determined as the start timing of the half-cycle pulse of the driving signal.

**15.** The vibration generating method according to claim 11, wherein a residual vibration control signal is generated based on the back EMF signal generated by the haptic actuator and the generated residual vibration control signal is applied to the haptic actuator, if the desired duration of vibration has passed.

**16.** The vibration generating method according to claim 15, wherein the residual vibration control signal is applied to the haptic actuator on a half-cycle pulse basis, and

wherein a direction of an initial half-cycle pulse of the residual vibration control signal is the same as a direction of a last half-cycle pulse of the driving signal.

**17.** The vibration generating method according to claim 16, wherein a period of the half-cycle pulse of the driving signal is the same as a period of a half-cycle pulse of the residual vibration control signal.

**18.** The vibration generating method according to claim 16, wherein a zero crossing point of the back EMF signal is determined as a start timing of a half-cycle pulse of the residual vibration control signal.

**19.** The vibration generating method according to claim 16, an extreme point of the back EMF signal is determined as a start timing of a half-cycle pulse of the residual vibration control signal.

**20.** The vibration generating method according to claim 15, further comprising selecting one of multiple resonant frequencies if the haptic actuator is a multi-resonant haptic actuator,
wherein periods of half-cycle pulses of the driving signal and the residual vibration control signal are determined based on a half-cycle pulse corresponding to the selected resonant frequency.

# FIG. 1

FIG. 2

BACK EMF SIGNAL

180

CONTROLLER
(Feedback Control)

155

DRIVING SIGNAL

FIG. 3

# FIG. 4

FIG. 5

(a)

400

(b)

# FIG. 6

200Hz

(a)

T=5ms

2.5ms

(b)

209Hz

(c)

# FIG. 7

(a)

(b)

FIG. 8

START TO DRIVE

S501 — APPLY UNIDIRECTIONAL PULSE

S502

MAKE HIGH IMPEDANCE
AND THEN DETECT BACK
EMF SIGNAL

ELIMINATE NOISE OF
BACK EMF SIGNAL

S503

S504

HAS DESIRED DURATION
OF VIBRATION PASSED?

Yes

No

DETECT ZERO CROSSING POINT
OF BACK EMF SIGNAL AND
APPLY OPPOSITE-DIRECTION
PULSE — S505

S506

MODE?

NORMAL STOP

S507

BREAKING

DETECT EXTREME POINT OF
BACK EMF SIGNAL AND APPLY
UNIDIRECTIONAL PULSE

S508

MAKE HIGH IMPEDANCE AND
THEN DETECT BACK EMF
SIGNAL AND ELIMINATE NOISE

DETECT EXTREME POINT OF
BACK EMF SIGNAL AND APPLY
OPPOSITE-DIRECTION PULSE

S509

IS
AMPLITUDE OF BACK
EMF SIGNAL EQUAL TO OR LESS THAN
CERTAIN VALUE?

No

Yes

S510

STOP TO DRIVE

# FIG. 9

(a)

(b)

# FIG. 10

(a)

f1

(b)

f2

(c)

f3

# FIG. 11

START TO DRIVE

S700 — SELECT ONE OF MULTIPLE RESONANT FREQUENCIES

S701 — APPLY UNIDIRECTIONAL PULSE OF SELECTED RESONANT FREQUENCY

S702 — MAKE HIGH IMPEDANCE AND THEN DETECT BACK EMF SIGNAL

S703 — ELIMINATE NOISE OF BACK EMF SIGNAL

S704 — HAS DESIRED DURATION OF VIBRATION PASSED? — Yes / No

S705 — DETECT ZERO CROSSING POINT OF BACK EMF SIGNAL AND APPLY OPPOSITE-DIRECTION PULSE

S706 — MODE? — NORMAL STOP / BREAKING

S707 — DETECT EXTREME POINT OF BACK EMF SIGNAL AND APPLY UNIDIRECTIONAL PULSE

S708 — MAKE HIGH IMPEDANCE AND THEN DETECT BACK EMF SIGNAL AND ELIMINATE NOISE

DETECT EXTREME POINT OF BACK EMF SIGNAL AND APPLY OPPOSITE-DIRECTION PULSE

S709 — IS AMPLITUDE OF BACK EMF SIGNAL EQUAL TO OR LESS THAN CERTAIN VALUE? — No / Yes

S710 — STOP TO DRIVE

FIG. 12

| 500 mV / div |
| -800 mV ofst |
| ↓ 1.415V |
| ↑ 2.369V |

| Timebase 11.8ms | | Tigger | C1 |
|---|---|---|---|
| | 5.00 ms / div | Stop | 1.695V |
| 100kS | 2.0 MS / s | Edge | Positive |

X1= -13.776ms   △X= 6.604ms

X2= 7.172ms   1 /△X= 151.42Hz

FIG. 13

| 500 mV / div |
| --- |
| -660 mV ofst |
| ↓ 2.339V |
| ↑ 2.381V |

| Tbase | -426.5ms |
| --- | --- |
| | 5.00 ms / div |
| 100kS | 2.0 MS / s |

X1= 421.495ms
X2= 416.710ms

| Tigger | C1 |
| --- | --- |
| Stop | 1.695V |
| Edge | Positive |

△X= -4.785ms
1 /△X= -209.0Hz

**INTERNATIONAL SEARCH REPORT**

International application No.

**PCT/KR2012/011837**

A. CLASSIFICATION OF SUBJECT MATTER

*H02N 2/14(2006.01)i*

According to International Patent Classification (IPC) or to both national classification and IPC

B. FIELDS SEARCHED

Minimum documentation searched (classification system followed by classification symbols)

H02N 2/14; B06B 1/02; H02P 31/00; G06F 3/01; H04B 1/40; G06F 3/041; G09G 5/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: actuator, vibration, resonance, one half cycle pulse, cellular phone, counter electro-motive force, actuator, resonance

C. DOCUMENTS CONSIDERED TO BE RELEVANT

| Category* | Citation of document, with indication, where appropriate, of the relevant passages | Relevant to claim No. |
|---|---|---|
| A | WO 2012-122443 A1 (ANALOG DEVICES, INC.) 13 September 2012<br>See paragraphs [39]-[56], [96]-[121], figures 1(a)-3, 14-18. | 1-20 |
| A | KR 10-2011-0080316 A (SAMSUNG ELECTRONICS CO., LTD.) 13 July 2011<br>See abstract, paragraphs [0021]-[0030], figures 2-6. | 1-20 |
| A | KR 10-2007-0086834 A (IMMERSION CORPORATION) 27 August 2007<br>See abstract, claims 1-11, figures 2-6. | 1-20 |
| A | KR 10-0902354 B1 (IMAGIS TECHNOLOGY) 12 June 2009<br>See paragraphs 21-47, claim 1, figures 2-3. | 1-20 |
| A | US 2006-0290662 A1 (HOUSTON, John et al.) 28 December 2006<br>See abstract, paragraphs [0196]-[0215], figures 31-39. | 1-20 |

☐ Further documents are listed in the continuation of Box C.　　☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 SEPTEMBER 2013 (24.09.2013) | **25 SEPTEMBER 2013 (25.09.2013)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2012/011837**

| Patent document cited in search report | Publication date | Patent family member | Publication date |
|---|---|---|---|
| WO 2012-122443 A1 | 13/09/2012 | US 2012-0229264 A1 | 13/09/2012 |
| KR 10-2011-0080316 A | 13/07/2011 | CN 102117149 A | 06/07/2011 |
| | | EP 2348384 A2 | 27/07/2011 |
| | | EP 2348384 A3 | 31/10/2012 |
| | | US 2011-0163985 A1 | 07/07/2011 |
| KR 10-2007-0086834 A | 27/08/2007 | EP 1817121 A1 | 15/08/2007 |
| | | JP 2008-521597 A | 26/06/2008 |
| | | JP 2012-020284 A | 02/02/2012 |
| | | JP 4997114 B2 | 18/05/2012 |
| | | KR 10-1179777 B1 | 04/09/2012 |
| | | KR 10-2011-0095967 A | 25/08/2011 |
| | | US 2006-0119573 A1 | 08/06/2006 |
| | | US 7639232 B2 | 29/12/2009 |
| | | WO 2006-071449 A1 | 06/07/2006 |
| KR 10-0902354 B1 | 12/06/2009 | CN 102177653 A | 07/09/2011 |
| | | US 2011-0204830 A1 | 25/08/2011 |
| | | WO 2010-047547 A2 | 29/04/2010 |
| US 2006-0290662 A1 | 28/12/2006 | AT 516864 T | 15/08/2011 |
| | | EP 1907086 A2 | 09/04/2008 |
| | | EP 1907086 A4 | 12/08/2009 |
| | | EP 1907086 B1 | 20/07/2011 |
| | | EP 2380640 A2 | 26/10/2011 |
| | | EP 2380640 A3 | 28/12/2011 |
| | | JP 2008-546534 A | 25/12/2008 |
| | | US 2011-0190058 A1 | 04/08/2011 |
| | | US 2011-0248817 A1 | 13/10/2011 |
| | | US 7919945 B2 | 05/04/2011 |
| | | WO 2007-002775 A2 | 04/01/2007 |
| | | WO 2007-002775 A3 | 19/04/2007 |

Form PCT/ISA/210 (patent family annex) (July 2009)